# EUROPEAN PATENT SPECIFICATION

(11) **EP 0 535 810 B1**
(45) Date of publication and mention of the grant of the patent: **06.03.1996**
(21) Application number: 92308123.6
(22) Date of filing: 08.09.1992
(51) Int. Cl.: C23C 16/40, B01L 3/14, C23C 16/50

(54) **Blood collection tube assembly**
Blutentnahmeröhrchen
Tube pour le prélèvement du sang

(30) Priority: 03.10.1991 US 771275
(43) Date of publication of application: 07.04.1993
(73) Proprietor: Becton Dickinson and Company, Franklin Lakes, New Jersey 07417-1880 (US)
(72) Inventor: Williams, Joel L., Cary, North Carolina 27511 (US)
(74) Representative: Ruffles, Graham Keith

(56) References cited:
- EP-A- 0 299 754
- PATENT ABSTRACTS OF JAPAN vol. 15, no. 398 (C-874)(4926) 9 October 1991 & JP-A-3162833
- DATABASE WPIL Section Ch, Week 8422, Derwent Publications Ltd., London, GB; Class C04, AN 84-136393221 & JP-A-59068674
- H.H.FUDENBERG ET AL. 'BASIC AND CLINICAL IMMUNOLOGY, 3rd EDITION' 1980 , LANGE MEDICAL PUBLICATIONS , LOS ALTOS CALIFORNIA

## Description

### 1. Field of the Invention

This invention relates to barrier coatings for providing an effective barrier against gas and water permeability for containers, especially plastic evacuated blood collection tubes.

### 2. Description of the Related Art

Containers made of polymers have found an ever increasing use as replacements for glass and metal containers. In particular, polyethylene terephthalate (PET) has been used in the fabrication of hottles. Bottles manufactured with PET exhibit excellent mechanical properties. However, such bottles are deficient when used for storing and transporting oxygen sensitive liquids. It has been found that containers made with PET are not sufficiently gas impervious and therefore do not maintain a desirable shelf-life. See, for example, U.S. Patent No. 3,733,309.

These deficiencies have restricted the use of polymers in containers, despite the advantages of polymers. These advantages include mechanical, thermal and optical properties and the adaptability of fabrication techniques for polymers, allowing the containers to be homogeneous, laminated and or coated. A further advantage of containers made from polymers is that they are generally light weight, less breakable and inexpensive to manufacture. Injection molding and extrusion, both possible methods for making articles from plastic, are inexpensive. With injection molding, large cavitation and decreased production times can increase production volume. Additionally, the injection molding process is not labor intensive and can be easily automated.

It is also known in the art that polymers such as PET can be laminated to an ethylene/vinyl alcohol copolymer (EVOH) to improve the gas barrier permeable properties of the polymer. Blends of PET and EVOH have been found to be useful in making containers having improved barriers to gas permeability. See, for example, U.S. Patent Nos. 3,595,740.

However, each of these materials has drawbacks. Ethylene-vinyl alcohol-based polymers lose barrier properties upon exposure to water and packages of this material cannot generally undergo retort, i.e., heating under pressurized steam for pasteurization. Vinylidene chloride-based polymers have been recognized as having excellent gas-barrier properties, but preparation of such vinylidene chloride-based polymers must generally be done under high pressure. Further, since vinylidene chloride-based barrier materials include halogen atoms, the disposal of such materials via incineration poses environmental problems. In addition, both vinylidene chloride-based polymers and ethylene-vinyl alcohol based polymers exhibit loss of adhesion after undergoing retort.

It is also known in the art that a silicon oxide based film could provide an effective barrier to oxygen permeability for two dimensional substrates as disclosed in European Patent Application, Publication Number 0 299 754. However, such films have not been used on three dimensional substrates such as plastic blood collection tubes.

With the increased emphasis on the use of plastic medical products, a special need exists for improving the barrier properties of articles made of polymers.

Such medical products that would derive a considerable benefit from improving their barrier properties include, but are not limited to, collection tubes and particularly those used for blood collection.

Blood collection tubes require certain performance standards to be acceptable for use in medical applications. Such performance standards include the ability to maintain greater than about 90% original draw volume over a one year period, to be radiation sterilizable and to be noninterfering in tests and analysis.

A critical performance standard of the blood collection tube is the draw volume retention. Draw volume retention depends on the existence of a partial vacuum, or reduced pressure, inside the tube. The draw volume changes in direct proportion to the change in vacuum (reduced pressure). Therefore, draw volume retention is dependent on good vacuum retention.

For example, it is important to maintain the vacuum over a period of time in order to provide appropriate storage life for those tubes prior to their being used. That is, it is important for the vacuum level to be maintained for a period of time prior to the time when a technician or a nurse uses the tube for collecting a blood sample.

Radiation sterilizable means that after the tube is exposed to certain levels of radiation in the sterilization process, there is substantially no change in optical or mechanical and functional properties.

Noninterference in performance of a tube's specifications means that the materials of the tube, such as glass or plastic materials do not interfere with testing and analysis that is typically performed on blood in the tube. Such tests include but are not limited to hematology, blood chemistry, blood typing, toxicology analysis and therapeutic drug monitoring. Furthermore, the tube must be capable of being subjected to automated machinery such as centrifuges.

Typically, plastic evacuated blood collection tubes have paper or foil labels applied over the outer surface. However, paper labels do not improve the barrier properties of the plastic tube and foil such as a metallic foil, is not transparent.

Therefore, it is desirable to be able to coat a plastic evacuated blood collection tube with a suitable barrier composition or blend thereof which can be conveniently applied to a plastic tube while not obscuring its contents, that would be able to meet certain performance standards and be effective and usable in medical applications.

### SUMMARY OF THE INVENTION

The present invention as defined in claim 1 provides a plastic composite container with a barrier composition disposed over an outer surface of the composite container. That is, a barrier composition is coated over the previously formed plastic container. Such a barrier composition improves the barrier properties of plastic containers, does not obscure the contents of the plastic containers and extends the shelf-life of plastic containers, especially plastic evacuated blood collection devices.

A desirable barrier composition which can be disposed over a plastic container preferably comprises a hard silicon oxide based film. Such a film desirably is derived from volatile organosilicon compounds.

A method for depositing a hard silicon oxide based film on a plastic blood collection tube, is as follows: (a) controllably flowing a gas stream including an organosilicon compound into a plasma; and (b) depositing a silicon oxide onto the article while maintaining a pressure of less than about 100 µm (100 microns) during the depositing.

The organosilicon compound is preferably combined with oxygen and helium and at least a portion of the plasma is preferably magnetically confined adjacent to the article during the depositing, most preferably by an unbalanced magnetron.

Preferably, the film provides a transparent, translucent or colorless appearance and may have printed matter applied thereon.

An advantage of the silicon oxide based films is its use in coating collection tubes in particular plastic collection tubes. Plastic tubes coated with the film are able to maintain far better vacuum retention and draw volume retention than previous tubes comprised of polymer compositions and blends thereof. In addition, the tube's resistance to impact is much better than that of glass. Most notably is the clarity of the film and its durability to substantially withstand resistance to impact.

### DESCRIPTION OF THE DRAWINGS

FIG. 1 is a perspective view of a typical blood collection tube with a stopper.

FIG. 2 is a longitudinal sectional view of the tube of FIG. 1 taken along line 2-2.

FIG. 3 is a longitudinal sectional view of a tube-shaped container similar to the tube of FIG. 1 without a stopper.

FIG. 4 is a longitudinal sectional view of a tube-shaped container similar to the tube of FIG. 1 with a stopper.

FIG. 5 is a schematic diagram illustrating a plasma system.

FIG. 6 is a schematic diagram illustrating a side sectional view of the plasma deposition chamber and its associated equipment as related to FIG. 5.

### DETAILED DESCRIPTION

The present invention may be embodied in other specific forms and is not limited to any specific embodiment described in detail which is merely exemplary.

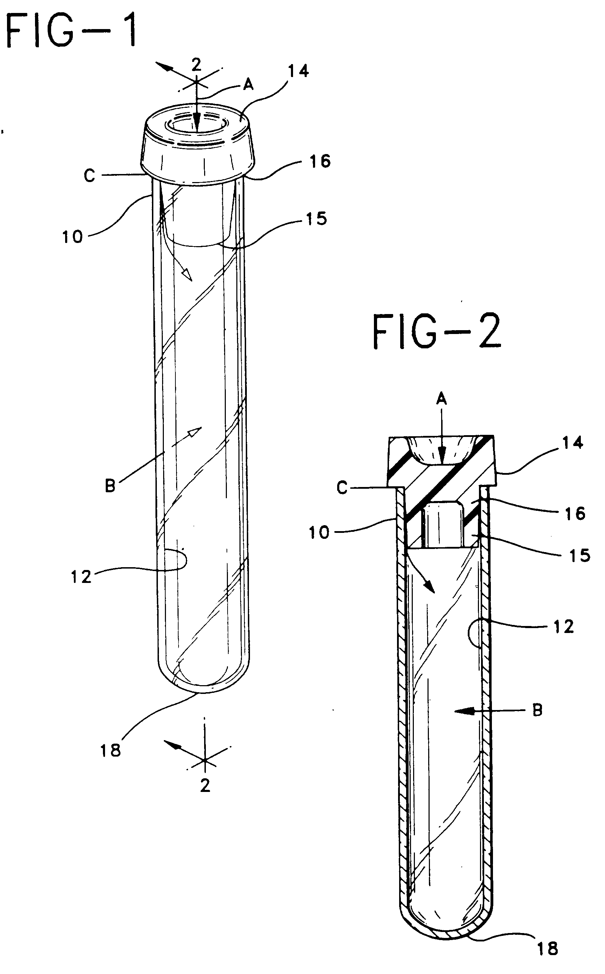

Referring to the drawings in which like reference characters refer to like parts throughout the several views thereof, FIGS. 1 and 2 show a typical blood collection tube **10**, having an open end **16**, a closed end **18** and stopper **14** which includes a lower annular portion or skirt 15 which extends into and presses against the inside walls **12** of the tube for maintaining stopper **14** in place. FIG. 2 schematically illustrates that there are three mechanisms for a change in vacuum in a blood collection tube: (A) gas permeation through the stopper material; (B) gas permeation through the tube material and (C) leak at the closure-tube interface. Therefore, when there is substantially no gas permeation and no leak, there is good vacuum retention and good draw volume retention.

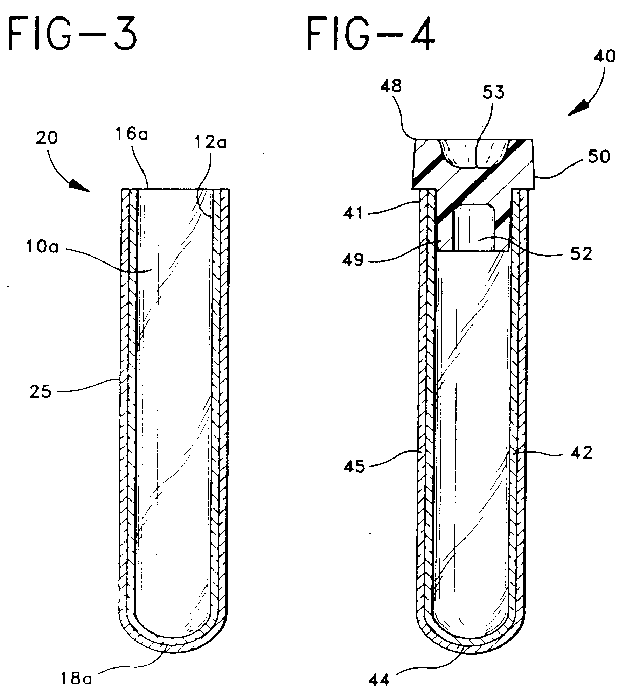

FIG. 3 shows the preferred embodiment of the invention, a plastic tube coated with a silicon oxide based film. The preferred embodiment includes many components which are substantially identical to the components of FIGS. 1 and 2. Accordingly, similar components performing similar functions will be numbered identically to those components of FIGS. 1 and 2, except that a suffix "a" will be used to identify those components in FIG. 3.

Referring now to FIG. 3, the preferred embodiment of the invention, collection tube assembly **20** comprises a plastic tube **10a**, having an open end **16a** and a closed end **18a.** A silicon oxide based film **25** extends over a substantial portion of the length of the tube which is upon the entire outer surface of the tube. As shown in FIG. 3, film label **25** covers all of the tube with the exception of open end **16a** thereof.

FIG. 4 illustrates an alternate embodiment of the invention, wherein collection tube assembly **40** comprises stopper **48** in place for closing open end **41** of tube **42.** As can be seen, stopper **48** includes an annular upper portion **50** which extends over the top edge of tube **42** as well as the top edge of film **45.** Stopper **48** includes a lower annular portion or skirt **49** which extends into and presses against the inside walls of tube **42** for maintaining stopper **48** in place. Also, the annular lower skirt **49** of stopper **48** defines a well **52** which, in turn, defines a septum portion **53** of stopper **48** for receiving a cannula therethrough. Thus, the user, once receiving a container such as that shown in FIG. 4 with a sample contained therein, may insert a cannula through septum **53** for receiving part or all of the contents in tube **42** to perform various tests on a sample. Covering a substantial portion of the length of the tube is film **45.** Film **45** covers substantially most of the tube with the exception of open end **41** thereof. FIG. 4 differs from the embodiment in FIG. 3 in that the tube is first evacuated with the simultaneous placement of stopper **48** therein followed by the application of film **45** thereover the tube.

An alternate embodiment of the invention also includes a film incorporating both the upper portion of the stopper, as well as the entire container tube. Such an embodiment may be utilized, for example, for sealing the container with the stopper in place. Once a sample has been placed in the tube, the sample cannot be tampered with by removal of the stopper. Additionally, serrations could be included at the tube, stopper interface. The serrations may be registered so that it can be determined if the sealed container has been tampered with.

It will be understood by practitioners-in-the-art, such tubes may contain reagents in the form of additives or coatings on the inner wall of the tube.

The silicon oxide based film forms a clear or translucent barrier on the outer surface of the plastic tube. The film is preferably translucent so that the contents of the plastic tube are visable to the observer at the same time identifying information may be displayed over the film after it is applied to the plastic tube.

The method for depositing a hard silicon oxide based film on an article is preferably conducted in a previously evacuated chamber of glow discharge from a gas stream. The gas stream preferably comprises at least three components: a volatilized organosilicon component, an oxygen component and an inert gas component.

Suitable organosilicon compounds for the gas stream are liquid at about ambient temperature and when volatilized have a boiling point above about ambient temperature and include methylsilane, dimethylsilane, trimethylsilane, diethylsilane, propylsilane, phenylsilane, hexamethyldisilane, 1,1,2,2-tetramethyl disilane, bis(trimethylsilane) methane, bis(dimethylsilyl) methane, hexamethyldisiloxane, vinyl trimethoxy silane, vinyl triethyoxy silane, ethylmethoxy silane, ethyltri methoxy silane, divinyltetramethyldisiloxane, divinylhexamethyltrisiloxane, and trivinylpentamethyltrisiloxane.

Among the preferred organosilicons are 1,1,3,3-tetramethyldisiloxane, hexamethyldisiloxane, vinyltrimethylsilane, methyltrimethoxysilane, vinyltrimethoxysilane and hexmethyldisilane.

The inert gas of the gas stream preferably is helium or argon. Most preferably the inert gas is helium.

The volatilized organosilicon component is preferably admixed with the oxygen component and the inert gas component before being flowed into the chamber. The quantities of these gases being so admixed are controlled by flow controllers so as to adjustably control the flow rate ratio of the gas stream components.

The organosilicon compound and oxygen of the gas stream during the depositing are preferably in a flow rate ratio between about 1.2:1 to about 1:1.8. When the inert gas is helium or argon, then the preferred flow rate ratio of organosilicon compound, oxygen and inert gas is about 1 to 1.8:1.5 to 1.8 to 2.3.

In addition to the necessary organosilicon, oxygen and inert gas in the gas stream, minor amounts (not greater than about 1:1 with respect to the organosilicon, more preferably about 0.4 to 1.1:1 with respect to the organosilicon) of one or more additional compounds in gaseous form may be included for particular desired properties. These additional compounds include, but are not limited to a lower hydrocarbon such as propylene, methane or acetylene, or nitrogen. In particular, nitrogen increases the deposition rate, improves the transmission and reflection optical properties on glass, and varies the index of refraction in response to varied amounts of N₂. The addition of nitrous oxide to the gas stream increases the deposition rate and improves the optical properties, but tends to decrease the film hardness.

A particularly preferred gas stream composition has 20 to 40 Scm³ organosilicon, 20 to 40 Scm³ O₂, 40 to 60 Scm³ He, 1 to 10 Scm³ propylene and 5 to 20 Scm³ N₂.

A flow discharge plasma is established in the previously evacuated chamber which is derived from one or more of the gas stream components, and preferably is derived from the gas stream itself. The article is positioned in the plasma, preferably adjacent the confined plasma, and the gas stream is controllably flowed into the plasma. The article is preferably conveyed into and out of the plasma adjacent the confined plasma for a sufficient number of passes to obtain the desired film and thickness.

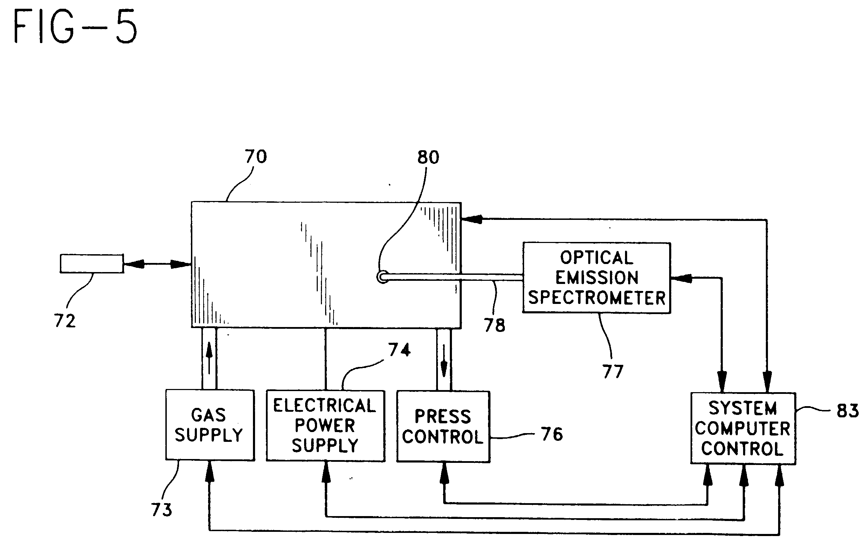

Referring to FIG. 5, the system for depositing a silicon oxide based film is schematically illustrated. The system comprises an enclosed reaction chamber **70** in which a plasma is formed and in which a collection tube **72,** is placed for depositing a thin film of material on it. The collection tube can be any vacuum compatible material, such as plastic. One or more gases are supplied to the reaction chamber by a gas supply system **73.** An electric field is created by a power supply **74,** and a low pressure is maintained by a pressure control system **76.** An optical emission spectrometer **77** is connected through an optical fiber light transmission medium **78** to the reaction chamber in some appropriate manner to couple the visible and near visible (especially the ultraviolet range) emission of the plasma to the spectrometer. A quartz window **80** in a side wall of the reaction chamber can be used to optically couple the optical emission spectrometer with the chamber. A general control system **83,** including a computer control portion, is connected to each of the other components of the system in a manner to receive status information from and send controlling commands to them.

The reaction chamber can be of an appropriate type to perform any of the plasma-enhanced chemical vapor deposition (PECVD) or plasma polymerization process.

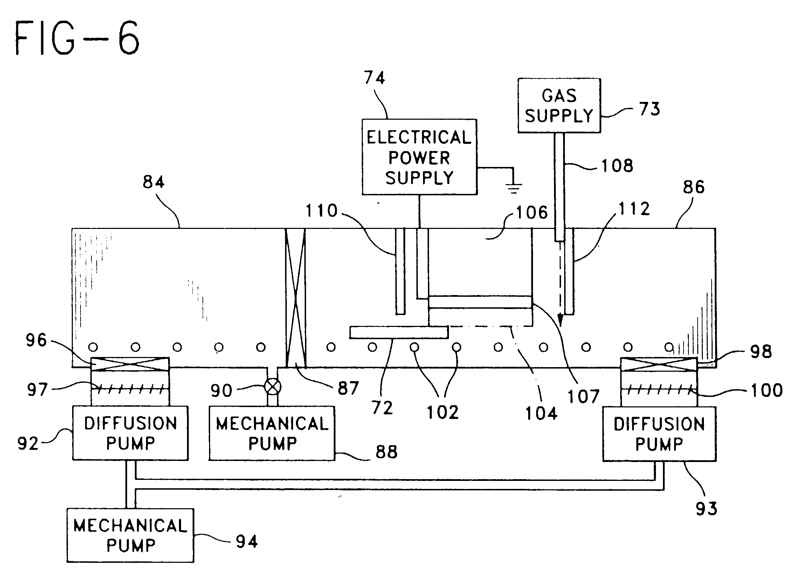

FIG. 6 shows a detailed side sectional schematic of the system of FIG. 5, for a PECVD or plasma polymerization process. In particular, reaction chamber **70** is divided into a load lock compartment **84** and a process compartment **86** by an isolation gate valve **87**. The pressure control system **76** includes a mechanical pump **88** connected to the load lock compartment **84** by a valve **90**. The pressure control system also includes diffusion pumps **92** and **93**, and an associated mechanical pump **94**. The diffusion pump **92** is connected to the load lock compartment **84** through an isolation gate valve **96** and an adjustable baffle **97**. Similarly, the diffusion pump **93** is connected to the process compartment **86** through an isolation gate valve **98** and an adjustable baffle **100**. Baffle **100** is controlled by the system control **83**, while a coating process is being carried out, in order to maintain the internal pressure at a desired value.

The collection tube to be coated is first loaded into the load lock compartment **84** with the valve **87** closed. The mechanical pump **88** then reduces the pressure most of the way to the high vacuum region. The diffusion pump **92** is then operated to reduce the pressure further, to about 5 x 10⁻⁶ Torr (say 6.7x10⁻⁴ N/m). The operating pressure is about 46 µm (microns) for a PECVD or plasma polymerization process and is achieved by flowing the process gases into the reaction chamber and throttling diffusion pump **93** using baffle **100**. During loading and unloading operations, diffusion pump **93** maintains the process compartment **86** at the operating pressure. Once the load lock compartment **84** is reduced to base pressure, the valve **87** is opened and tube **72** moved into process compartment **86**.

A typical deposition process involves passing tube **72** back and forth through a plasma region **104,** a number of times in order that the thin film deposited on the outer surface of the tube has a desired uniform thickness.

A magnetron is positioned within process compartment **86,** formed of a magnetic structure **106** and a cathode **107.** Power supply **74** has its output connected between cathode **107** and a metallic body of the process compartment. The magnetron creates an appropriate combination of magnetic and electrical fields in plasma region **104** in order to create a plasma there when the proper gases are introduced into the process compartment. The tube is maintained electrically isolated and is passed directly through the plasma region. This is accomplished by a plurality of rollers **102.**

The gaseous components necessary for the plasma to form in plasma region **104** are introduced into process compartment **86** by a conduit **108.** Gas flows within process compartment **86** from diffusion pump **93.** A pair of baffles **110** and **112** on either side of the magnetron help to confine the gas flow to plasma region **104.**

A plastic blood collection tube coated with the silicon oxide based film or blends thereof may effectively be used in such applications as routine chemical analysis, biological inertness, hematology, blood chemistry, blood typing, toxicology analysis or therapeutic drug monitoring and other clinical tests involving body fluids.

It will be understood that it makes no difference whether the plastic composite container is evacuated or not evacuated in accordance with this invention. The presence of barrier composition on the outer surface of the container has the effect of maintaining the general integrity of the container holding a sample so that it may be properly disposed of without any contamination to the user. In addition, the barrier composition makes the container stronger overall because of the cushioning characteristics of the barrier composition.

The silicon oxide based film or blends thereof used in accordance with this disclosure, may contain conventional additives and ingredients which do not adversely affect the properties of articles made therefrom.

A further aspect of the invention is a method for forming plastic containers with a polymer blend composition and then coating the container with a silicon oxide based film.

The following examples are not limited to any specific embodiment of the invention, but are only exemplary.

### EXAMPLE 1

### METHOD FOR COATING A PLASTIC BLOOD COLLECTION TUBE WITH A SILICON OXIDE BASED FILM

An enclosed reaction chamber is evacuated to a base pressure of not greater than about 3 x l0⁻⁶ Torr (say 4 x 10⁻⁴ N/m). The load lock is vented to atmosphere while the chamber is maintained under high vacuum. Then the load lock is evacuated with the plastic tube loaded therein. The chamber pressure is adjusted to a desired value by adjusting the baffle over the diffusion pump. The load lock diffusion pump is closed and the valve isolating the load lock and the chamber is opened. After the pressure in the chamber is stabilized, the power supply is turned on and adjusted to the desired value and a glow discharge plasma is established in the chamber. An emission spectrum from the control program is used to find the appropriate oxygen to inert gas ratio. The organosilicon flow into the chamber is then adjusted until the desired oxygen to inert gas ratio is obtained. The plastic tube is then conveyed back and forth through the plasma region until the desired coating thickness is achieved while continuing to monitor the process conditions. Once the desired film thickness is obtained, the system is shut down and the coated tube is removed.

### EXAMPLE 2

### PLASTIC TUBE COATED WITH A SILICON OXIDE BASED FILM AS COMPARED TO PLASTIC TUBE WITHOUT A BARRIER COMPOSITION

Saturated plastic tubes, 13x75mm, made of polypropylene, with and without a silicon oxide based film, were placed in a controlled environment at 40°C and 4 atm. The 40°C and 4 atm provide conditions for accelerated ambient aging.

The silicon oxide based film was applied to tubes in category A. Tubes in category B, the control group, did not have a barrier coating.

Each tube was tested for oxygen transmission rates using the OxTran 1000 instrument by Mocon, Inc.

| Tube | O₂ Transmission Rate (ml per tube per day) |
|---|---|
| A | 0.09066 |
| B | 0.0011 |

The results show that a lower O₂ transmission rate was achieved with a silicon oxide based film on a plastic container as compared to a plastic tube with no barrier coating.

### EXAMPLE 3

### COMPARISON OF PLASTIC TUBES COATED AND FLAT SUBSTRATES COATED WITH A SILICON OXIDE BASED FILM

Flat substrates made of polyethyleneterephthalate (PET), 1 mil (say 0.0254 mm) in thickness, and saturated plastic tubes, 13x75mm, made of PET were coated with a silicon oxide based film. The oxygen permeabilities of the substrates were measured at 25°C and the oxygen transmission rate of the plastic tubes were predicted based on the permeability data results of the substrates.

The results of the oxygen transmission rates are given below:

| SAMPLE | Oxygen Transmission Rate (ml/Tube/Day) | Oxygen Permeability (ml/M /atm/Day) |
|---|---|---|
| PET Tube | 0.0023 | --- |
| PET/SiO₂ Tube | 0.0001 | --- |
| PET 1 mil substrate | --- | 80 |
| PET/SiO₂ substrate | --- | 1.06 |

The results show that a lower transmission rate will be achieved with the silicon oxide based film on a plastic tube as compared to a plastic tube with no silicon oxide based film.

## Claims

1. A method of forming a barrier coating on a plastics blood collection tube, characterized in that the barrier coating is applied by depositing a silicon oxide based film on the tube in a previously evacuated chamber by glow discharge using plasma enhanced discharge, the method comprising:
(a) vaporizing an organosilicon component and admixing the volatilized organosilicon component with an oxygen component and an inert gas component to form a gas stream exterior the chamber;
(b) establishing a glow discharge plasma in the chamber from one or more of the gas stream components;
(c) controllably flowing the gas stream into the plasma while confining at least a portion of the plasma therein; and
(d) conveying the plastic blood collection tube into and out of the plasma adjacent the confined plasma.

2. The method according to claim 1, wherein the plastic tube is electrically isolated from the chamber except for contact with the confined plasma.

3. The method according to claim 2, further comprising magnetically confining at least a portion of the plasma adjacent to the tube during the depositing.

4. The method according to claim 3, wherein the organosilicon compound and oxygen of the gas stream being flowed into the plasma are in the flow rate ratio between 1.2:1 to 1:1.8 and the inert gas of the gas stream being flowed into the plasma is helium or argon in an amount effective to increase the deposition rate and the hardness of the deposited silicon oxide.

5. The method according to claim 4, wherein the inert gas is helium in a ratio in the range from 1:1.5 to 1:2.3.

6. The method according to claim 1, wherein the organosilicon compound is 1,1,3,3-tetramethyldisiloxane, hexamethyldisiloxane, vinyltrimethylsilane, methyltrimethoxysilane, vinyltrimethoxysilane or hexamethyldisilane.

## Patentansprüche

1. Verfahren zur Bildung eines Sperrüberzugs auf einem Blutentnahmeröhrchen aus Plastik, dadurch gekennzeichnet, daß der Sperrüberzug durch Abscheiden eines Films auf der Basis von Siliciumoxid durch Glimmentladung mit Benutzung einer Plasma verbesserten Entladung in einer vorher evakuierten Kammer auf das Röhrchen aufgebracht wird, wobei das Verfahren folgende Schritte aufweist:
(a) Verdampfen einer siliciumhaltigen organischen Komponente und Vermischen der verflüchtigten siliciumhaltigen organischen Komponente mit einer Sauerstoffkomponente und einer inerten Gaskomponente, um außerhalb der Kammer einen Gasstrom zu bilden;
(b) Schaffung eines Glimm-Entladungsplasmas in der Kammer aus einer oder mehreren Komponenten des Gasstroms;
(c) kontrollierbares Fließen des Gasstromes in das Plasma bei gleichzeitigem Einschließen wenigstens eines Teils des Plasmas in diesem und
(d) Hinein- und Herausführen des Blutentnahmeröhrchens aus Plastik in das und aus dem Plasma in der Nähe des eingeschlossenen Plasmas.

2. Verfahren nach Anspruch 1, bei dem das Plaströhrchen gegenüber der Kammer elektrisch isoliert ist, ausgenommen für den Kontakt mit dem eingeschlossenen Plasma.

3. Verfahren nach Anspruch 2, das außerdem das magnetische Einschließen wenigstens eines Teils des Plasmas nahe des Röhrchens während des Abscheidens umfaßt.

4. Verfahren nach Anspruch 3, bei dem die siliciumhaltige organische Verbindung und der Sauerstoff in dem Gasstrom, der in das Plasma fließt, ein Verhältnis der Strömungsmengen zwischen 1.2:1 und 1:1.8 aufweisen und das inerte Gas des Gasstromes, der in das Plasma fließt, Helium oder Argon in einer Menge ist, die eine Steigerung der Auftragrate und der Härte des aufgebrachten Siliciumoxids bewirkt.

5. Verfahren nach Anspruch 4, bei dem das inerte Gas Helium mit einem Verhältnis im Bereich von 1:1,5 bis 1:2,3 ist.

6. Verfahren nach Anspruch 1, bei dem die siliciumhaltige organische Verbindung 1,1,3,3-Tetramethyldisiloxan, Hexamethyldisiloxan, Vinyltrimethylsilan. Methyltrimethoxysilan, Vinyltrimethoxysilan oder Hexamethyldisilan ist.

## Revendications

1. Procédé de formation d'un revêtement barrière sur un tube de prélèvement sanguin en plastique, caractérisé en ce que le revêtement barrière est appliqué en déposant une pellicule à base d'oxyde de silicium sur le tube dans une chambre évacuée au préalable par décharge luminescente en utilisant une décharge activée par plasma, le procédé consistant à:
(a) vaporiser un constituant organosilicié et mélanger le constituant organosilicié volatilisé avec un constituant oxygéné et un constituant gaz inerte pour former un courant de gaz à l'extérieur de la chambre;
(b) établir un plasma à décharge luminescente dans la chambre à partir d'un ou plusieurs des constituants du courant de gaz;
(c) laisser le courant de gaz s'écouler de façon contrôlée dans le plasma tout en y confinant au moins une partie du plasma; et
(d) introduire et extraire le tube de prélèvement sanguin en plastique du plasma de façon adjacente au plasma confiné.

2. Procédé selon la revendication 1, dans lequel le tube en plastique est électriquement isolé de la chambre, mis à part le contact avec le plasma confiné.

3. Procédé selon la revendication 2, comprenant en outre le confinement magnétique d'au moins une partie du plasma de façon adjacente au tube pendant le dépôt.

4. Procédé selon la revendication 3, dans lequel le composé organosilicié et l'oxygène du courant de gaz s'écoulant dans le plasma sont dans le rapport de débit de 1,2:1 à 1:1.8, et le gaz inerte du courant de gaz s'écoulant dans le plasma est l'hélium ou l'argon, en une quantité efficace pour augmenter la vitesse de dépôt et la dureté de l'oxyde de silicium déposé.

5. Procédé selon la revendication 4, dans lequel le gaz inerte est l'hélium dans un rapport dans la gamme de 1:1,5 à 1:2,3.

6. Procédé selon la revendication 1, dans lequel le composé organosilicié est le 1,1,3,3-tétraméthyldisiloxane, l'hexaméthyldisiloxane, le vinyltriméthylsilane, le méthyltriméthoxysilane, le vinyltriméthoxysilane ou l'hexaméthyldisilane.
